# EUROPÄISCHE PATENTSCHRIFT

(11) **EP 0 330 922 B1**
(45) Veröffentlichungstag und Bekanntmachung des Hinweises auf die Patenterteilung: **26.08.1998**
(21) Anmeldenummer: 89102684.1
(22) Anmeldetag: 16.02.1989
(51) Int. Cl.: H05K 3/22

(54) **Umschmelzprozess für Leiterplatten**
Reflow process for circuit boards
Procédé de refusion pour plaques de circuit

(30) Priorität: 02.03.1988 DE 3806774
(43) Veröffentlichungstag der Anmeldung: 06.09.1989
(73) Patentinhaber: Siemens Nixdorf Informationssysteme Aktiengesellschaft, 33102 Paderborn (DE)
(72) Erfinder: Brabetz, Bernhard, Dipl.-Ing., D-8025 Unterhaching (DE)
(74) Vertreter: Epping, Wilhelm, Dr.-Ing.

(56) Entgegenhaltungen:
- DE-A- 3 433 251
- FR-A- 2 499 228
- US-A- 3 548 062
- US-A- 4 373 658
- US-A- 4 580 716

## Beschreibung

Die Erfindung betrifft ein Verfahren zum Umschmelzen von galvanischen Zinn- oder Zinn-Blei-Schichten auf Leiterplatten.

Bekanntlich hängt die Zuverlässigkeit aller elektronischen Geräte weitgehend auch von der Qualität der eingebauten Leiterplatten ab. Die Qualität der Leiterplatten wiederum ist wesentlich abhängig von der Qualität ihrer Durchkontaktierungen, ihrer Lagenverklebung sowie der Lötfreudigkeit der Leiterplattenoberfläche.

Zur Erleichterung der Lötarbeiten auf gedruckten Schaltungen werden die Kupfer-Leiterbahnen vielfach galvanisch verzinnt, um die Oxidation der Kupferoberflächen zu vermeiden. Hierbei wird für höchste Qualitätsansprüche eine galvanische Zinn- oder Zinn-Blei-Legierung mit einem Zinn-Blei-Verhältnis von 60:40 in einer Stärke von 12 bis 15 µm aufgebracht und nachfolgend diese Schicht durch einen Wärmeprozeß, beispielsweise durch Einwirkung mit Wärmestrahlung oder durch Eintauchen in ein heißes Ölbad, ungeschmolzen (DE-OS 25 02 900). Dies ist notwendig, da derartige galvanisch abgeschiedene Schichten sehr schlecht lötbar sind.

Durch die thermische Belastung der Leiterplatten beim Umschmelzen (Aufschmelzen) der galvanisch aufgebrachten Metallschichten treten in der Leiterplatte Spannungen auf und die Haftung zwischen Harz und Kupfer nimmt ab. Als Folge dieser Erscheinungen besteht die Gefahr, daß die Leiterplatte beschädigt wird. Diese Beschädigung kann sowohl eine Delamination (Lagentrennung) als auch ein Abriß der Durchkontaktierung sein.

Bisher wurden die Leiterplatten bei Atmosphärendruck umgeschmolzen. Leiterplattenbeschädigungen mußten dabei in Kauf genommen werden.

Der Erfindung liegt die Aufgabe zugrunde, ein Verfahren zum Umschmelzen von Zinn- oder Zinn-Blei-Schichten auf Leiterplatten anzugeben, durch das Beschädigungen in diesen Leiterplatten durch thermische Belastung vermieden werden.

Diese Aufgabe wird erfindungsgemäß dadurch gelöst, daß der Umschmelzprozeß in einem Überdruckbehälter bei erhöhtem Gasumgebungsdruck erfolgt.

Der Vorteil der Erfindung besteht vor allem darin, daß die beim Umschmelzen der Zinn-Blei-Schichten in den Leiterplatten aufgrund unterschiedlicher Ausdehnungskoeffizienten verschiedener Materialien auftretenden Spannungen durch den allseitswirkenden erhöhten Umgebungsdruck soweit kompensiert werden, daß eine Leiterplattenbeschädigung zum Beispiel durch Delaminierung oder Durchkontaktierungsrisse verhindert wird.

Aus der FR-A-2 449 228 und der US-A-4 373 658 ist es bekannt, bei der Dampfphasenlötung die zu vereinigenden Gegenstände in einem Überdruckbehälter mittels Dampf auf die erforderliche Löttemperatur zu erhitzen. Durch eine derartige Dampfphasenlötung können auch elektronische Bauelemente auf Leiterplatten aufgelötet werden.

Die Ansprüche 2 bis 5 betreffen vorteilhafte Weiterbildungen des erfindungsgemäßen Verfahrens.

Die Weiterbildung gemäß Anspruch 2 ermöglicht eine einfache Zufuhr der benötigten Wärmemenge für das Umschmelzen durch Infrarotstrahlung.

Die Weiterbildung gemäß Anspruch 3 bietet eine weitere einfache Möglichkeit für die Zufuhr der benötigten Wärmemenge für das Umschmelzen durch ein temperaturgesteuertes Ölbad.

Gemäß Anspruch 4 ist es auch möglich, die benötigte Wärmemenge durch Erhitzen des Druckgases zu erzeugen.

Gemäß Anspruch 5 ist das Druckgas als Schutzgas ausgelegt. Hierdurch wird eine Oxidation der Metallflächen verhindert.

Die Erfindung wird anhand eines Ausführungsbeispiels beschrieben. In einem Druckbehälter befindet sich eine Ölwanne mit dem Umschmelzöl mit zum Beispiel 215°C. Die Temperatur des Umschmelzöls wird mittels eines geregelten Heizsystems konstant gehalten. Über dem Umschmelzbad ist die umzuschmelzende Leiterplatte angeordnet. Der Druckbehälter wird auf 18 bar Stickstoffdruck bei einer Stickstofftemperatur von zum Beispiel 60° C gebracht. Nach Erreichen des gewünschten Druckes wird die zu behandelnde Leiterplatte in das Ölbad gesenkt und ca. 30 Sekunden darin belassen, um den Umschmelzvorgang im Öl durchzuführen. Danach wird die Leiterplatte wieder aus dem Ölbad entnommen und im Druckbehälter auf Raumtemperatur abgekühlt. Der Stickstoffdruck wird auf Atmosphärendruck abgesenkt und die behandelte Leiterplatte aus dem Druckbehälter entfernt. Statt Stickstoff kann auch Kohlendioxyd als Druckgas bzw. jedes Gas, das ein Oxidieren der ungeschmolzenen Metallfläche verhindert und auch nicht zu schnell im Umschmelzöl gelöst wird, Verwendung finden. Je nach Struktur der Leiterplatte ist es teilweise erforderlich, den Druck auf 60 bar zu erhöhen.

## Patentansprüche

1. Verfahren zum Umschmelzen von galvanischen Zinn- oder Zinn-Blei-Schichten auf Leiterplatten, **dadurch gekennzeichnet,** daß der Umschmelzprozeß in einem Überdruckbehälter bei erhöhtem Gasumgebungsdruck erfolgt.

2. Verfahren nach Anspruch 1, **dadurch gekennzeichnet,** daß die benötigte Wärmemenge für das Umschmelzen durch Infrarotstrahlung zugeführt wird.

3. Verfahren nach Anspruch 1, **dadurch gekennzeichnet,** daß die benötigte Wärmemenge für das Umschmelzen durch ein temperaturgesteuertes Ölbad zugeführt wird.

4. Verfahren nach Anspruch 1, **dadurch gekennzeichnet,** daß die benötigte Wärmemenge durch Erhitzung des Druckgases erzeugt wird.

5. Verfahren nach einem der vorhergehenden Ansprüche, **dadurch gekennzeichnet,** daß das Druckgas als Schutzgas ausgelegt ist.

## Claims

1. Process for reflowing electroplated tin layers or tin/lead layers on printed circuit boards, characterized in that the reflow process is carried out in a pressurized container at increased ambient gas pressure.

2. Process according to Claim 1, characterized in that the amount of heat needed for the reflow is supplied by infrared radiation.

3. Process according to Claim 1, characterized in that the amount of heat required for the reflow is supplied by a temperature-controlled oil bath.

4. Process according to Claim 1, characterized in that the amount of heat required is generated by heating the pressurized gas.

5. Process according to one of the preceding claims, characterized in that the pressurized gas is provided as protective gas.

## Revendications

1. Procédé de refusion de couches galvaniques d'étain ou d'étain-plomb sur des plaques de circuit, caractérisé en ce que le processus de refusion se produit dans un récipient sous pression à une pression ambiante gazeuse élevée.

2. Procédé selon la revendication 1, caractérisé en ce que la quantité de chaleur nécessaire pour la refusion est apportée par rayonnement infrarouge.

3. Procédé selon la revendication 1, caractérisé en ce que la quantité de chaleur nécessaire pour la refusion est apportée par un bain d'huile à température commandée.

4. Procédé selon la revendication 1, caractérisé en ce que la quantité de chaleur nécessaire est produite en chauffant le gaz comprimé.

5. Procédé selon l'une des revendications précédentes, caractérisé en ce que le gaz comprimé est conçu en tant que gaz protecteur.
